# EUROPEAN PATENT APPLICATION

(11) **EP 3 570 342 A1**
(43) Date of publication of application: **20.11.2019**
(21) Application number: 18382341.8
(22) Date of filing: 18.05.2018
(51) Int. Cl.: H01L 51/50, C09K 11/06

(54) **ABX3 COMPOUNDS WITH PEROVSKITE CRYSTALLINE STRUCTURE INFILTRATED WITHIN A POROUS METAL OXIDE FILM**

(71) Applicant: Consejo Superior de Investigaciones Científicas (CSIC), 28006 Madrid (ES); Universidad de Sevilla, 41013 Sevilla (ES)
(72) Inventor: RUBINO, Andrea, 41092 Sevilla (ES); GALISTEO LÓPEZ, Juan Francisco, 41092 Sevilla (ES); MÍGUEZ GARCÍA, Hernán Ruy, 41092 Sevilla (ES); CALVO ROGGIANI, Mauricio, 41092 Sevilla (ES); ANAYA MARTÍN, Miguel, 41013 Sevilla (ES)
(74) Representative: Pons

(57) **Abstract**

The invention relates to a material which comprises ABX₃ compounds with perovskite crystalline structure infiltrated within a porous metal oxide film, wherein A and B are cations , and X is an halide. The invention also relates to the process to obtain the referred material and its use for light emitting, color converter and surface protective coating.

## Description

The invention relates to a material which comprises ABX₃ compounds with perovskite crystalline structure infiltrated within a porous metal oxide film which is supported on a substrate. The invention also relates to the process to obtain the referred material and its use for light emitting, color converter and surface protective coatings.

### BACKGROUND ART

The advent of ABX₃ perovskite compounds (where A is Cs: cesium, FA: formamidinium or MA: methylammonium, B is Pb or Sn and X is halide) in the field of nanostructured semiconductors prepared by solution process received a freshly impulse since 2012. This astonishing development has been boosted principally by the impressive photo-conversion efficiencies achieved with CH₃NH₃PbI₃-based solar cells. At the same time, interesting and valuable photo-emission properties were also discovered in this ABX₃ perovskite family. However, the architecture implemented for perovskite solar cells was not satisfactorily applied in light emissive devices. In this case, a very thin layer of active material is needed in order to prevent non radiative recombination while allowing an efficient charge injection (see Q. A. Akkerman, M. Gandini, F. Di Stasio, P. Rastogi, F. Palazon, G. Bertoni, J. M. Ball, M. Prato, A. Petrozza, L. Manna, Nat. Energy 2016, 2, 16194 and Z.-K. Tan, R. S. Moghaddam, M. L. Lai, P. Docampo, R. Higler, F. Deschler, M. Price, A. Sadhanala, L. M. Pazos, D. Credgington, F. Hanusch, T. Bein, H. J. Snaith, R. H. Friend, Nat. Nanotechnol. 2014, 9, 687). For this reason, the seek of perovskite thin films with good optical performance is nowadays an active field of research devoted to understand the fundamental processes that take place in the film after initial excitation by photon absorption or charge injection.

At the same time, ABX₃ nanocrystals (nc-ABX3) have awakened a strong interest since they opened the door to the exploitation of the exciting properties associated to the quantum confinement regime. Their tunable and narrow band emissions with high quantum yields, are distinctive characteristics of nc-ABX3 that possibilities their use as color converter coatings (S. Liu, M. He, X. Di, P. Li, W. Xiang, X. Liang, Chem. Eng. J. 2017, 330, 823; I. Dursun, C. Shen, M. R. Parida, J. Pan, S. P. Sarmah, D. Priante, N. Alyami, J. Liu, M. I. Saidaminov, M. S. Alias, A. L. Abdelhady, T. K. Ng, O. F. Mohammed, B. S. Ooi, O. M. Bakr, ACS Photonics 2016, 3, 1150). Nc-ABX₃ preparation was traced from well-stablished synthetic processes based on semiconductor nanocrystals colloidal chemistry simplifying the experimental routes that lead to nc-ABX₃ with different stoichiometry, particle shape and size. ( F. Zhang, H. Zhong, C. Chen, X. G. Wu, X. Hu, H. Huang, J. Han, B. Zou, Y. Dong, ACS Nano 2015, 9, 4533). These methods require a careful control of the experimental conditions: concentration of compounds, surface functionalization, type of solvent, reaction temperature, etc. Once nanocrystals were synthesized in liquid phase, additional experimental steps are necessary to purify or to separate them from the synthesis medium. Furthermore, applications in optoelectronic devices require the deposition of the colloids as a thin layer coating without altering the high luminescence of the colloids (Y. Kim, E. Yassitepe, O. Voznyy, R. Comin, G. Walters, X. Gong, P. Kanjanaboos, A. F. Nogueira, E. H. Sargent, ACS Appl. Mater. Interfaces 2015, 7, 25007). To overcome these *extra* processes other ABX₃ nanocrystal synthetic approaches have been developed: the use of porous structures that act as nanoreactors. In this limited-volume reaction systems, from the perovskite compounds it is possible to generate ABX₃ nanocrystals in the range of 2-10 nm size exhibiting properties governed by quantum confinement effects. Mesostructured particles with narrow pore size distribution successfully address the condition to synthesize confined perovskite (see D. N. Dirin, L. Protesescu, D. Trummer, I. V. Kochetygov, S. Yakunin, F. Krumeich, N. P. Stadie, M. V. Kovalenko, Nano Lett. 2016, 16, 5866 and S. Demchyshyn, J. M. Roemer, H. Groiß, H. Heilbrunner, C. Ulbricht, D. Apaydin, A. Böhm, U. Rütt, F. Bertram, G. Hesser, M. C. Scharber, N. S. Sariciftci, B. Nickel, S. Bauer, E. D. Gtowacki, M. Kaltenbrunner, Sci. Adv. 2017, 3, e1700738).

However, the deposition of that mentioned powders as a film prevents their uses in many applications due to the lack of optical quality derived from the large size and aggregation of host particles. Recently, our group developed a synthesis of MAPbI₃ within optical quality mesostructured thin films with controlled porosity and thickness. In this case, the templating of the scaffold demands a careful control of the synthetic conditions of a process that requires several days to achieve a stable structure before the inflitration with the perovskite compounds (see M. Anaya, A. Rubino, T. C. Rojas, J. F. Galisteo-López, M. E. Calvo, H. Míguez, Adv. Opt. Mater. 2017, 5, 1601087 and WO 2016/193124). Electrochemical etched porous silicon or anodized columnar nanoporous alumina were also used as optical quality films nanoreactors to produce nc-ABX₃ inside the pores with a certain degree of inhomogeneity in their spatial distribution (S. Demchyshyn, J. M. Roemer, H. Groiß, H. Heilbrunner, C. Ulbricht, D. Apaydin, A. Böhm, U. Rütt, F. Bertram, G. Hesser, M. C. Scharber, N. S. Sariciftci, B. Nickel, S. Bauer, E. D. Gtowacki, M. Kaltenbrunner, Sci. Adv. 2017, 3, e1700738). In addition, both approaches demonstrate a beneficial effect that these matrices confer to the nc-ABX₃ in terms of photo-stability.

Therefore, it would be desirable to have ABX₃ nanocrystals with highly emissive properties.

### SUMMARY OF THE INVENTION

A first aspect of the present invention relates to a material characterized in that it comprises:
- ABX₃ compounds with perovskite crystalline structure, wherein A and B are cations , and X is an halide; and
- a porous metal oxide film having pores of sizes between 1 nm and 1000 nm,
wherein the ABX₃ compounds are infiltrated within the porous metal oxide film that is supported on a substrate.

Hereinafter "ABX₃ compounds" of the invention refers to compounds of formula ABX₃ wherein A and B are cations, preferably wherein A is cesium (Cs), formamidinium (FA) or methylammonium (MA); B is Pb or Sn; and X is an halide,
"Halide" is F, CI, Br or I, and preferably Br or I.

"ABX₃@MOₓ" refers to ABX₃ compounds with perovskite crystalline structure (optionally referred to also as "ABX₃ perovskite compounds") infiltrated within a porous metal oxide;
"@" refers to the inclusion or the embedment of the first compound into the second compound; and
"MOₓ" refers to the metal porous metal oxide. Examples of MOₓ include among others SiO₂, TiO₂, SnO₂, ZnO, ZrO₂, Nb₂O₅, CeO₂, Fe₂O₃, Fe₃O₄, V₂O₅, Cr₂O₃, HfO₂, MnO₂, Mn₂O₃, Co₃O₄, NiO, Al₂O₃ and In₂O₃, and preferably MOₓ is SiO₂.

In another embodiment the invention relates to the material as defined above, wherein A is cesium (Cs), formamidinium (FA) or methylammonium (MA), and preferably MA.

In another embodiment the invention relates to the material as defined above, wherein B is Pb or Sn, and preferably Pb.

In another embodiment the invention relates to the material as defined above, wherein X is CI, Br o I, and preferably Br or I.

In another embodiment the invention relates to the material as defined above, wherein the ABX₃ compounds are of formula ABX₃@MOₓ, wherein: ABX₃ has the previously defined meaning; and
MOₓ is a porous metal oxide, and preferably is selected from SiO₂, TiO₂, SnO₂, ZnO, ZrO₂, Nb₂O₅, CeO₂, Fe₂O₃, Fe₃O₄, V₂O₅, Cr₂O₃, HfO₂, MnO₂, Mn₂O₃, Co₃O₄, NiO, Al₂O₃ and In₂O₃, and more preferably is SiO₂.

In another embodiment the invention relates to the material as defined above, wherein the ABX₃ compounds are MAPbBr₃@SiO₂ or MAPbl₃@SiO₂.

In another embodiment the invention relates to the material as defined above, wherein the ABX₃ compounds are of formula nc-ABX₃@MOₓ, wherein "nc-ABX₃@MOₓ" refers to ABX₃ nanocrystals infiltrated within a porous metal oxide.

In another embodiment the invention relates to the material as defined above, wherein the ABX₃ compounds of formula nc-ABX₃@MOₓ are selected from nc-MAPbBr₃@SiO₂ or nc-MAPbl₃@SiO₂.

The combination of polymers with ABX₃ compounds results in higher performance and/or more stable layers. Accordingly, oligomers of poly(dimethyl)siloxane (PDMS) have been used to infiltrate porous structures to create a hybrid polymer-porous metal oxide flexible film. Regarding the presence of voids between nanocrystals and the inter-connectivity of the pore structure of MOx layers, PDMS oligomers polymerize within ABX₃ embedded in a MOₓ matrix to prepare a high emissive flexible film. Polymerization was made at a temperature below 100 °C in order to prevent the degradation of the perovskite nanocrystals inside the MOₓ matrix. It is worth to mention that this sort of *ex-situ* method overcomes the incompatibility between the solvents used to dissolve PDMS oligomers and ABX₃ compounds since the process does not require the dispersion of ABX₃ nanocrystals in an appropriate solvent.

In another embodiment the invention relates to the material as defined above, wherein the material further comprises an infiltrated polymer.

In another embodiment the invention relates to the material as defined above, wherein the ABX₃ compounds are of formula polymer@nc-ABX₃@MOₓ, wherein:
nc-ABX₃@MOₓ has the previously defined meaning; and
"polymer" is a polymer.

In another embodiment the invention relates to the material as defined above, wherein the polymer of the ABX₃ compounds of formula polymer@nc-ABX₃@MOₓ is selected from poly(dimethyl)siloxane (PDMS) and derivatives, poly(urethane) and derivatives, poly(alkyl)acrylates and derivatives, poly(aryl)acrylates and derivatives, poly(alkyl)metacrylates and derivatives, poly(aryl)methacrylate and derivatives or poly(carbonates) and derivatives, and preferably poly(dimethyl)siloxane (PDMS).

A "polymer derivative" refers to any modification that allows to change the ramification of the polymer chain or to integrate a new functional group in the polymer chain.

In another embodiment, the invention relates to the material as defined above, wherein the ABX₃ compounds of formula polymer@nc-ABX₃@MOₓ are selected from PDMS@nc-MAPbBr₃@SiO₂ and PDMS@nc-MAPbl₃@SiO₂.

In another embodiment the invention relates to the material as defined above, wherein the ABX₃ compounds are detached from the supporting substrate.

Another aspect of the present invention relates to the process to obtain the material as defined above, characterized in that it comprises the following steps:
a) preparing porous metal oxide films by means of nano colloid suspensions deposited on a substrate; and
b) infiltrating ABX₃ compounds or ABX₃ compounds precursors within the porous metal oxide films obtained in step (a) by means of spin coating.

The "ABX₃ compounds precursors" refers to:
- a solution (i) constituted by Cs, MA or FA halides or a mix of them in an appropriated solvent selected from dimethyl sulfoxide , N,N-dimethyl formamide or gamma butyrolactone,
- a solution (ii) constituted by Pb(II) or Sn(II) halides, and
- a mix of solution (i) and solution (ii).
In another embodiment the invention relates to the process as defined above, wherein the nano colloid suspensions for preparing the porous metal oxide film of step (a) are suspensions of SiO₂, TiO₂, SnO₂, ZnO, ZrO₂, Nb₂O₅, CeO₂, Fe₂O₃, Fe₃O₄, V₂O₅, Cr₂O₃, HfO₂, MnO₂, Mn₂O₃, Co₃O₄, NiO, Al₂O₃ or In₂O₃ nanoparticles.

The starting point in nc-ABX₃@MOₓ synthesis is the dip-coating deposition of porous metal oxide (MOx) nano-colloids that leads to porous films with optical quality since the use of particles with sizes in the range of tens of nanometers prevents the diffuse scattering of the light. The voids between the particles of these MOₓ layers constitute around 35-40% of the total volume of the film and they are fully accessible from the top. The controlled deposition of MOₓ nano-colloids, and particularly SiO₂ nano-colloids, *via* dip coating directs to a porous film with a narrow pore distribution size centered at r = 7 nm. Both features (porosity and pore size distribution) of these nanoparticulated layers are indispensable to act as host of ABX₃ compounds that were successfully infiltrated by spin coating.

The control of nc-ABX₃ size by the concentration of ABX₃ compounds can be rationalized in terms of the different rates of the processes that take place in the porous matrix as the solvent leaves the inorganic scaffold. At the initial stage of the deposition step, the infiltration rate of the MOₓ porous matrix, preferably SiO₂, is much faster than the solvent evaporation as a consequence of the low vapor pressure of the solvent, preferably of the N,N-dimethylformamide (DMF). This fact suppressed the inhomogeneous accumulation of mass in different sections of the film achieving a uniform embedding of ABX₃ compounds for all concentrations analyzed.

In another embodiment, the invention relates to the process as defined above, wherein the ABX₃ compounds infiltrated within porous metal oxide film of step (b) further comprises the infiltration of a polymer, preferably wherein the polymer is selected from poly(dimethyl)siloxane (PDMS) and derivatives, poly(urethane) and derivatives, poly(alkyl)acrylates and derivatives, poly(aryl)acrylates and derivatives, poly(alkyl)metacrylates and derivatives, poly(aryl)metacrylates and derivatives or poly(carbonates) and derivative, and more preferably wherein the polymer is poly(dimethyl)siloxane (PDMS).
The treatment of the polymer@ABX₃@MOₓ at temperatures below the glass transition temperature of the polymer allows us to lift-off the material from the substrate to create a self-standing film. The obtention of nc-ABX₃ as a flexible film improves the manipulation and the use to cover surfaces with arbitrary shapes. Additionally, the encapsulation of the nanocrystals by PDMS has an advantageous effect over the photo-stability of the films which is a key issue in this type of materials. The preservation of the optical properties against the environment agents presents special relevance in order to spread the applications of these types of ABX₃ compounds. In another embodiment, the invention relates to the process as defined above, which further comprises the step of detachment of the infiltrated porous metal oxide from the supporting substrate, and preferably wherein the detachment step is performed by means of lowering the temperature below the glass transition temperature of the polymer.

Another aspect of the present invention relates to the use of the material as defined above, for light emitting, color converter and surface protective coating.

The emission wavelength is selected by changing the concentration of the ABX₃ compounds and/or the chemical composition of these compounds.

Another aspect of the present invention relates to a light emitting, color converter or surface protective coating which comprises the material as defined above.

Unless otherwise indicated, all technical and scientific terms used herein have the same meaning as commonly understood by one of ordinary skilled in the art to which this invention belongs. Methods and materials similar or equivalent to those described herein can be used in the practice of the present invention. Throughout the description and claims the word "comprise" and its variations are not intended to exclude other technical features, additives, components, or steps. Additional objects, advantages and features of the invention will become apparent to those skilled in the art upon examination of the description or may be learned by practice of the invention.

The following examples and drawings are provided by way of illustration and are not intended to be limiting of the present invention.

### BRIEF DESCRIPTION OF THE DRAWINGS

**Fig. 1****.** Pore size distribution inside the SiO₂ nanoparticles matrix

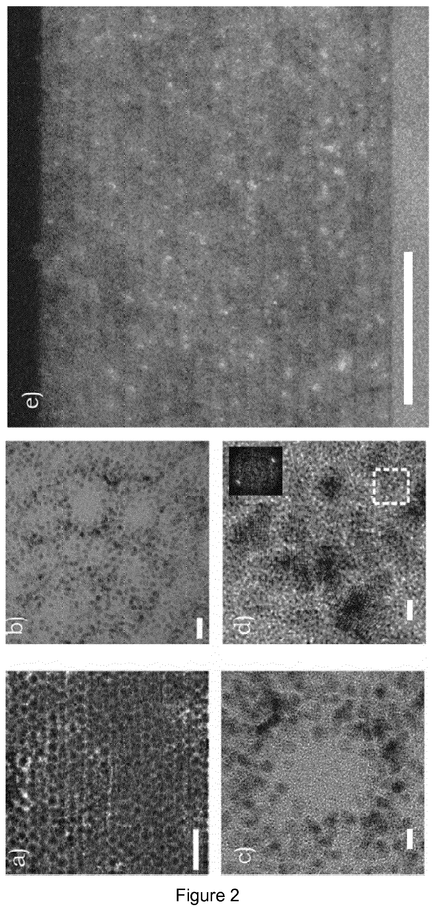

**Fig. 2****. (a)** HADDF-STEM image of a cross section of a SiO₂ nanoparticles mesoporous film containing MAPbBr₃ nanocrystals; scale bar is 100 nm. From **b)** to **d)** High-resolution TEM images, with different magnification of the dashed areas, of MAPbBr₃ nanocrystals infiltrated in the voids of the mesoporous matrix; scale bar is 10 nm in **b),** 3.5 nm in **c)** and 1 nm in **d).** The inset in **d)** shows the digital diffraction pattern of area selected in the same panel. **(e)** SEM backscattered electron image of a cross section of a SiO₂ nanoparticles mesoporous film including MAPbBr3 nanocrystals prepared from a solution with a 5% of compounds. Scale bar is 500 nm
**Fig. 3****.** Box chart representation of the size distribution of perovskite nanocrystals corresponding to the synthesis with a 5% and 20% concentrated solutions of compounds

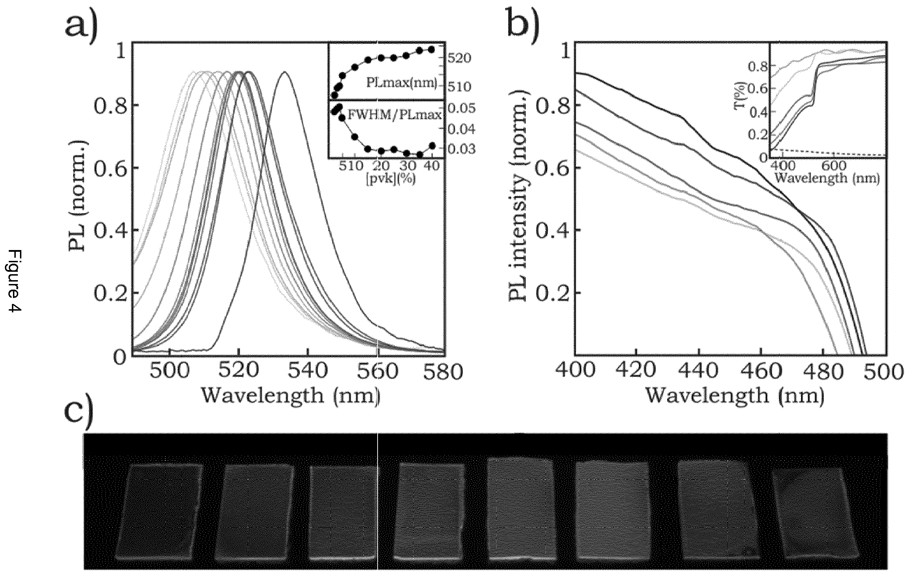

**Fig. 4****. (a)** Normalized photoluminescence (PL) spectra of nc-MAPbBr₃ synthesized within the voids of SiO₂ scaffold, starting from solutions with different precursor concentrations (%, MABr/PbBr₂). Gradual shift of the maximum of emission is registered from 523 nm, 40% to 507 nm, 2%. The emission of bulk material is represented with solid black line (maximum emission at 533 nm). Inset: evolution of the PL maximum (top) and FWHM (bottom) with the increase of perovskite precursor concentrations. **(b)** Normalized photo-excitation spectra of nc-MAPbBr₃ obtained with precursor concentration of 5%; 10%, 20%, 30% and 40% from light grey to dark grey sequentially. The inset displays the transmittance of same samples, using the same gray scale and the diffuse transmittance (black dashed line) of the 5% sample. **(c)** Photograph under UV light (λ=312 nm) of nc-MAPbBr₃ prepared (initial precursor concentration decreases from the right to the left). Scale bar is 1cm.
**Fig. 5a** Normalized PL spectra of MAPbI₃ nanocrystals infiltrated in a silica nanoparticles (diameter of 30 nm) scaffold and prepared by varying the concentration of compounds solutions (MAI + PbI₂) from light gray to dark gray 5%, 10%, 15%, 20%, 25%, 30% . The black line corresponds to the bulk material.
**Fig. 5b** Normalized PL spectra of MAPbBr₃ nanocrystals from a 20% concentrated solution infiltrated in mesoporous film built up with nanoparticles of TiO₂, SnO₂, SiO₂ 30 nm diameter and SiO₂ 10 nm diameter (from dark gray to light gray respectively). The black line corresponds to the emission of a bulk bromide perovskite film.
**Fig. 5c** Normalized PL spectra of MAPbI₃ nanocrystals from a 20% concentrated solution infiltrated in mesoporous film built up with nanoparticles of TiO₂ (red line), SnO₂(blue line), SiO₂ with a diameter of 30 nm, SiO₂ with a diameter of 10 nm, SnO₂ and TiO₂ (From dark gray to light gray respectively) The black line corresponds to the emission of a bulk iodide perovskite film
**Fig. 6a** Representative scheme of the fabrication of flexible emissive film constituted by PDMS@nc-MAPBr₃@SiO₂
**Fig. 6b** Daylight image of a flexible film made of PDMS@nc-MAPBr₃@SiO₂ self-standing film.
**Fig. 6c** Camera pictures of flexible perovskite-silica structures exposed to UV light.
**Fig. 6d** Camera pictures of flexible perovskite-silica structures immersed in water and
**Fig. 6e** Camera pictures of flexible perovskite-silica structures under a water jet.
**Fig. 6f** Concentration-dependent quantum yield (QY) measurements from samples with PDMS (light grey) and without PDMS (dark grey).
**Fig. 6g** Evolution of the photoemission of nc-MAPbBr₃-silica system (prepared from a 5% precursor solution) encapsulated with PDMS (dashed line) and without PDMS (solid line).

### EXAMPLES

### Preparation of nanoparticles scaffolds.

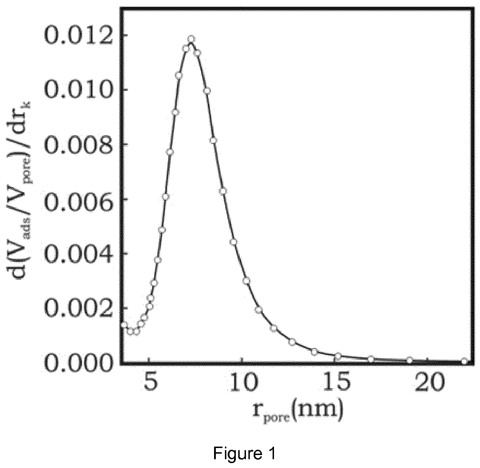

The synthesis of the nanoparticles has been conducted through the sol-gel method. Starting from the hydrolysis of titanium isopropoxide in MilliQ water (stirring for one hour) and by subsequent filtration of the formed precipitate, it proceeds to condensation in the presence of tetramethylammonium hydroxide in an oven at 120°C for 3 h. After the hydrothermal treatment, the solution is centrifuged twice at 14,000 rpm for 10 minutes. The supernatant was finally diluted to 2% in methanol. In the case of colloidal dispersion of SnO₂ and SiO₂ we used, respectively dispersion at 15% w/w in water and dispersion at 1% w/w of SiO₂ nanoparticles from Dupont (Ludox). For the preparation of the matrices in the form of porous nanoparticulated films, the solutions of the different porous metal oxides were deposited on low fluorescence glass substrates, after cleaning with ethanol, acetone and isopropanol, using the technique of dip coating. In particular, we perform consecutive immersions of the substrate in a dispersion of TiO₂ (20 times), SnO₂ (28 times), and SiO₂ (140 times) with a withdrawal speed of 100 mm/min, in order to obtain a thickness of 1 micrometer. The so obtained matrices have been stabilized at a temperature comprised between 100°C and 400°C.
The controlled deposition of SiO₂ nanocolloids *via* dip coating directs to a porous film with a narrow pore distribution size centered at r = 7 nm (Figure 1).

### Synthesis of perovskite nanocrystals.

The synthesis procedure of perovskite compounds consists in the preparation of a solution of compounds (mixture of lead methylammonium and halide in a molar ratio 1: 1) in N,N-dimethylformamide (DMF) or dimethyl sulfoxide (DMSO) or in a mix of both solvents, and then the subsequent deposition of the solution on the matrices, by means of spin coating. By spreading the compounds through the inter-particle voids and a heat treatment (100°C for one hour) we promote the formation of perovskite nanocrystals that grow within these porous structures. Following an already established procedure, all the steps related to the synthesis of perovskite compounds are conducted inside a glovebox in order to eliminate the oxygen and humidity interference and have a controllable and reproducible procedure.

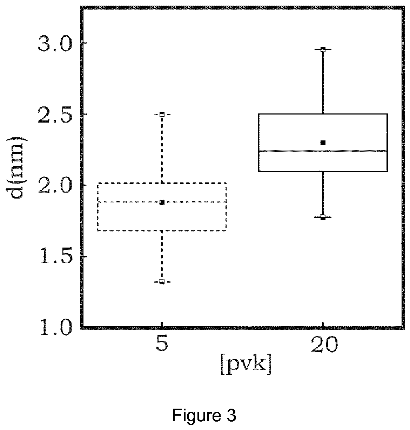

A microstructural analysis of the SiO₂-ABX₃ ensemble, made by transmission electron microscopy (TEM), discloses the shape of the spherical SiO₂ particles stacked as a layer (Figure 2a). A zoomed analysis of a section of this image reveals smaller primary particles occupying the voids of the porous structure and surrounding SiO₂ particles (Figure 2b and Figure 2c). A closer analysis under high resolution TEM image of these particles reveals a crystalline structure with an interatomic distances of 2.2 Angstrom (0.22 nm) that can be assigned to the [2,2,0] family planes of MAPbBr₃ perovskite (Figure 2d). A cross-section section field-emission scanning electron microscopy FESEM image of this ABX₃ infiltrated SiO₂ film reveals an uniform 1µm-thickness layer where the white spots correspond to Z-heavier Pb atoms of ABX₃ perovskite (Figure 2e) obtained after the thermal treatment. The effect of precursor concentration on ABX₃ crystal size was estimated from TEM images and presented in a box plot type graph (Figure 3). It can be seen that the diameter average values of ABX₃ nanocrystals are 1.8 nm and 2.3 nm for 5% and 20% concentrations respectively

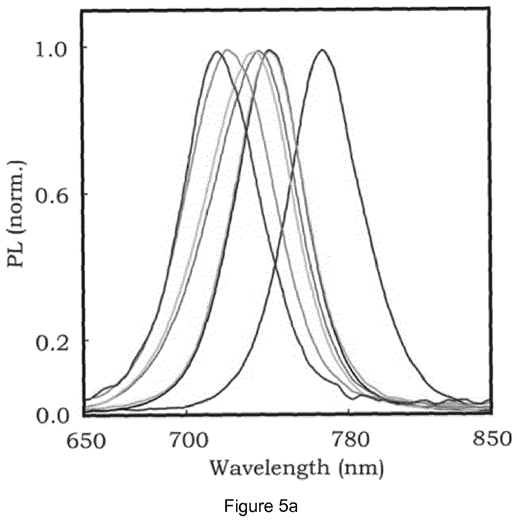

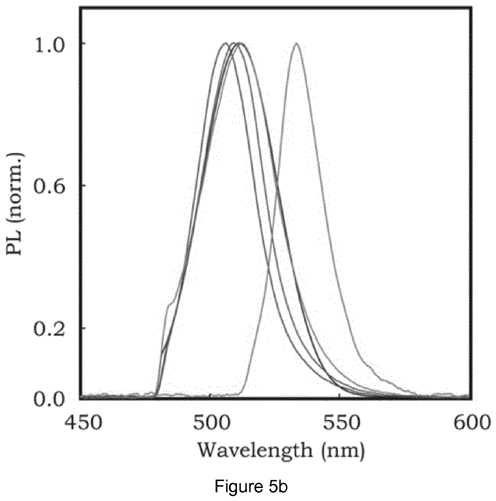

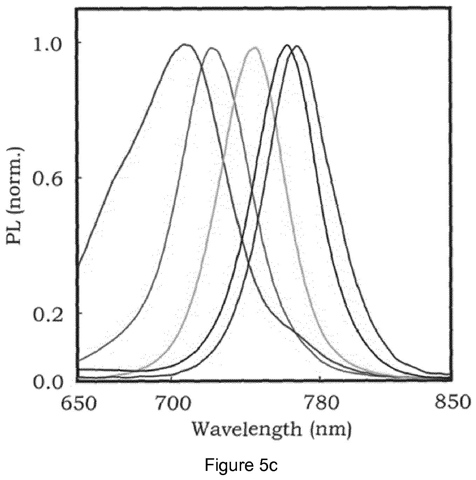

The dip coating methodology allows us to prepare 1µm thickness (see Figure 2e) layers with multistep dip coating of low concentrated suspensions. SiO₂ layers are transparent in most the ultraviolet (UV) range and completely transparent in the visible region of the electromagnetic spectrum. This ensures that all measured optical properties belong to the MAPbBr₃ nanocrystals (nc-MAPbBr₃) located at the pore voids of SiO₂ layer. The emission spectra of nanocrystals obtained with different ABX₃ precursor concentrations are shown in Figure 4a. It is easy to notice that the spectral position of the emission maximum gradually shifts to higher energies as the precursor concentration decreases (Figure 4a inset top). The lowest concentration tested (2%) presents an emission peak centered at λₘₐₓ=504 nm which corresponds to a ΔE=0.155eV when it is compared with an homogeneous layer of MAPbBr₃ (λₘₐₓ=538 nm). The spectral shift of the peaks is directly related to quantum confinement effects that occur in the assynthesized MAPbBr₃ nanocrystals. In addition, the value of the full width half medium (FWHM) normalized at the spectral position of the maximum emission follows a decreasing tendency as ABX₃ precursor concentration increases. The shift in the spectral position of the emission is in agreement with the shift in the photoexcitation spectra of SiO₂ layers infiltrated with different MAPbBr₃ concentrations. This effect is noticed in Figure 4b where the shape of these photoexcitation spectra also reveals a sharp profile near photoexcitation threshold indicating a narrow nanocrystal size distribution in each infiltrated SiO₂ layer. In order to verify the optical quality of the infiltrated samples, we explored the ballistic transmittance of the films (T) in the visible range. The decrease of T is due to the strong absorption of nc-MAPbBr₃. However, the high T values at λ>510 nm (more than 75%) prove that the optical quality of the nc-MAPbBr₃@SiO₂ layers is kept after the infiltration (inset in Figure 4b). In addition, the very low value of the diffuse transmittance (dashed line in the inset) demonstrates not only that mentioned semi-transparency functionality but also the capability of the films to form image once light overpasses them in any direction. Beyond this interesting optical property that allows the use of this type of samples in many applications as screens or displays, it is interesting to notice that the lack of diffuse scattering is a consequence of the absence of large nc-MAPbBr₃ grains and/or large voids between them. In Figure 4c, is shown a series of SiO₂ films with identical thickness and infiltrated with different concentrations of MAPbBr₃ compounds under UV irradiation. A bright emission coming from homogeneous infiltrated layers as well as a slight change in the emitted color from each sample is detected in the image.
A similar experiment was carried out by infiltrating MAPbI₃ perovskite compounds in SiO₂ porous layers obtaining an equivalent behavior to the one attained with MAPbBr₃. In this case, a large spectral shift of the maximum emission is obtained as the precursor's concentration diminishes (Figure 5a). Moreover, the infiltration of either MAPbBr₃ or MAPbI₃ was tested in other type of porous metal oxide layers as TiO₂ (12 nm particle size) or SnO₂(8 nm particle size) and SiO₂ layer with 10 nm particle size. In all cases, we noticed a blue-shift in the emission when compared with homogeneous MAPbBr₃ or MAPbl3 (Figure 5b and 5c respectively).

### Preparation of the flexible films polymerization and detachment.

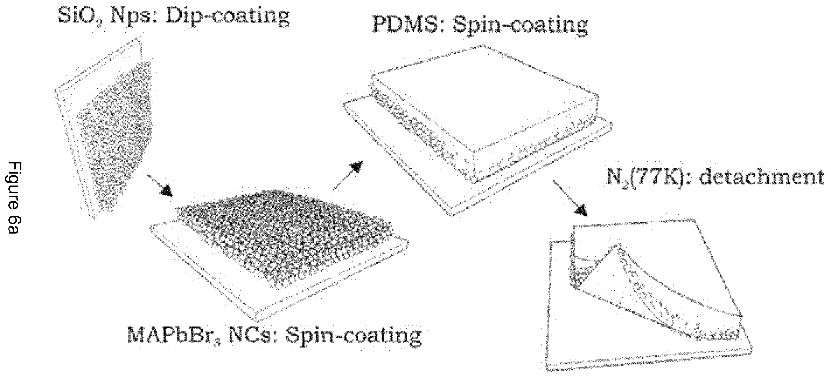

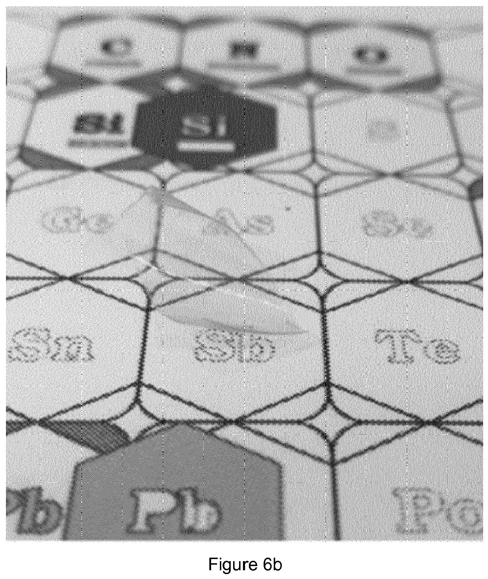

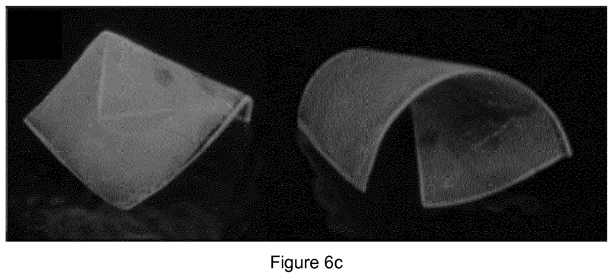

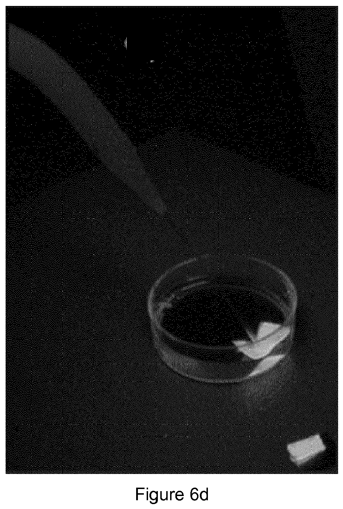

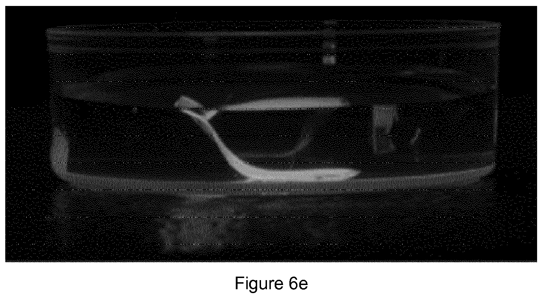

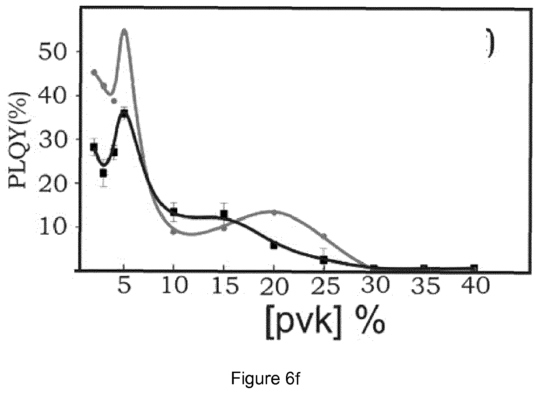

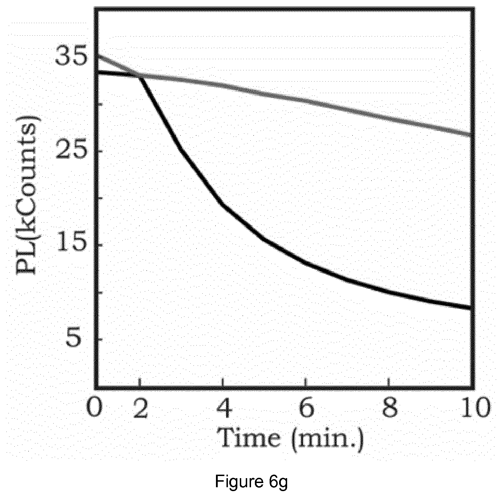

To obtain a self-standing and flexible structure starting from the infiltrated matrices, we have prepared, in accordance with an already known process (Chem. Mater. 2010, 22, 3909-3915), a solution containing a silicone elastomer and a cross-linker (Sylgard 184 elastomer kit, Dow Corning) in a mass ratio of 8 to 1. The solution obtained was deposited on the matrix, then spin coated at 700rpm for 60s and eventually heated at 90°C for one hour. In this way the solution can penetrate the porous structure using the same voids where the perovskite nanocrystals didn't grow and form a layer of PDMS that incorporates the porous metal oxide nanoparticles and the perovskite. Subsequently we realize incisions in the edges of the sample that afterwards is immersed in liquid nitrogen in order to facilitate the detachment of the film from the glass substrate. And once brought back to ambient temperature, the removal will be finally completed.
As it was aforementioned, we were able to polymerize in the resulting voids of these nc-ABX₃ structures a structural polymer. The general scheme of the process is disclosed in Figure 6a. After this treatment, it has been obtained a self-standing film that includes nc-MAPbBr₃ embedded in SiO₂ layer. The flexible film maintains the optical properties of the original one, being these identified by its transparency (Figure 6b) and its emission (Figure 6c) that are not lost after the treatment. In order to test the invention films, it has been measured the emission of PDMS/nc-MAPbBr₃/SiO₂ flexible material when they are totally immersed in water (Figure 6d) or under a water-jet (Figure 6e). It can be clearly seen that the nanocrystals emission under UV light and the flexibility of the film are kept while water is surrounding the films.
An important characteristic of the nanocrystals is the high emission quantum yield (QY) exhibited by the samples prepared at different perovskite precursor concentrations and plotted comparatively the values obtained for the same type of sample with and without PDMS infiltration. In Figure 6f, QYs for the same type of sample with and without PDMS infiltration are plotted. Results indicate that the QY evolution with the precursor concentration follows the same maximum in QY is detected for a 5% concentration. Furthermore, it can be noticed that the infiltration of PDMS improves QY for a certain range of concentrations reaching values as high as 55%.

In order to analyze the effect of PDMS as surface protector, it has been followed the photo-emission under continuous illumination of MAPbBr₃ nanocrystals with and without PDMS. The results of this experiment are shown in Figure 6e where these two types of films are compared. Although in both cases the emission decreases with time, it can be seen that after 10 minutes of illumination, the PDMS infiltrated film presents an 80% of the initial emission intensity whereas in the bare film this value is only a 22% of the initial emitted light intensity.

### Optical Characterization.

The analysis of the optical properties of photoemission and the relative transient were conducted using a fiber-coupled spectrophotometer in which a continuous wave pump laser beam was focused with an achromatic lens producing a spot size of 250 µm². The excitation wavelength was 450 nm.

Quantum yield measurements were carried out using the Hamamatsu C9920-02 Absolute PL Quantum Yield Measurement System that presents a Xenon lamp, a monochromator and an integration sphere. The excitation wavelength was set to 450 nm.
Photoexcitation spectra were collected using a fluorimeter (Fluorolog-3 from Horiba) with a double monochromator and a spot of 1 × 1 cm, in a front-face configuration.
For the measurements of diffuse and direct transmittance, conducted within the visible limits, the Cary5000 spectrophotometer (UV-Vis-NIR) was used, equipped with an internal DRA-2500 (PMT / PbS version).

### Structural Characterization.

TEM. The preparation of samples involves a Focused Ion Beam cut to obtain a lamella of the cross section of the film. Then, the characterization was carried out by means of a FEI Talos F200S scanning/transmission electron microscope. SEM. The images of the cross sections of the infiltrated porous matrices were obtained using a microscope (FESEM) Hitachi 5200. For these measurements, the nanoparticles were deposited on silicon substrates.

## Claims

1. A material **characterized in that** it comprises:
• ABX₃ compounds with perovskite crystalline structure, wherein A and B are cations, and X is an halide; and
• a porous metal oxide film having pores of sizes between 1 nm and 1000 nm,
wherein the ABX₃ compounds are infiltrated within the porous metal oxide film that is supported on a substrate.

2. The material according to claim 1, wherein A is cesium (Cs), formamidinium (FA) or methylammonium (MA).

3. The material according to any of claims 1 or 2, wherein B is Pb or Sn.

4. The material according to any of claims 1 to 3, wherein X is CI, Br or I.

5. The material according to any of claims 1 to 4, wherein the ABX₃ compounds are of formula ABX₃@MOₓ, wherein:
ABX₃ has the previously defined meaning; and
MOₓ is a porous metal oxide.

6. The material according to claim 5, wherein MOₓ is a porous metal oxide selected from SiO₂, TiO₂, SnO₂, ZnO, ZrO₂, Nb₂O₅, CeO₂, Fe₂O₃, Fe₃O₄, V₂O₅, Cr₂O₃, HfO₂, MnO₂, Mn₂O₃, Co₃O₄, NiO, Al₂O₃ and In₂O₃.

7. The material according to any of claims 1 to 6, wherein the ABX₃ compounds are of formula nc-ABX₃@MOₓ, and nc-ABX₃@MOₓ refers to ABX₃ nanocrystals infiltrated within a porous metal oxide.

8. The material according to any of claims 1 to 7, wherein the ABX₃ compounds are of formula polymer@nc-ABX₃@MOₓ, wherein:
nc-ABX₃@MOₓ has the previously defined meaning; and
polymer is a polymer.

9. The material according to claim 8, wherein the polymer is selected from poly(dimethyl)siloxane (PDMS) and derivatives, poly(urethane) and derivatives, poly(alkyl)acrylates and derivatives, poly(aryl)acrylates and derivatives, poly(alkyl)metacrylates and derivatives, poly(aryl)methacrylate and derivatives or poly(carbonates) and derivatives.

10. The material according to any of claims 1 to 9, wherein the ABX₃ compounds are detached from the supporting substrate.

11. Process to obtain the material of any of claims 1 to 10, **characterized in that** it comprises the following steps:
a) preparing porous metal oxide films by means of nano colloid suspensions deposited on a substrate; and
b) infiltrating ABX₃ compounds or ABX₃ compounds precursors within the porous metal oxide film obtained in step (1) by means of spin coating.

12. The process according to claim 11, which further comprises the step of infiltrating a polymer after performing step (b).

13. The process according to any of claims 11 or 12, which further comprises the step of detaching the infiltrated porous metal oxide film from the substrate

14. Use of the material defined in any of claims 1 to 10,for light emitting, color converter or surface protective coating.

15. A light emitting, color converter or surface protective coating which comprises the material of any of claims 1 to 10.
